# EUROPEAN PATENT SPECIFICATION

(11) **EP 3 945 759 B1**
(45) Date of publication and mention of the grant of the patent: **02.04.2025**
(21) Application number: 21000190.5
(22) Date of filing: 19.07.2021
(51) Int. Cl.: H05K 7/14, H05K 3/22, H05K 1/02

(54) **PRINTED BOARD FOR MODULAR, MULTI-CHANNEL ACTUATOR CONTROLLING ELECTRICAL RECEIVERS, ESPECIALLY IN BUILDING AUTOMATION SYSTEMS**
LEITERPLATTE FÜR MODULARE, MEHRKANALSAKTOR, DIE ELEKTRISCHE EMPFÄNGER STEUERN, INSBESONDERE IN GEBÄUDEAUTOMATISIERUNGEN
CARTE IMPRIMÉE POUR ACTIONNEUR MODULAIRE À CANAUX MULTIPLES CONTROLANT DES RÉCEPTEURS ÉLECTRIQUES, EN PARTICULIER DANS LES SYSTÈMES D'AUTOMATISATION DU BÂTIMENT

(30) Priority: 27.07.2020 PL 43481820
(43) Date of publication of application: 02.02.2022
(73) Proprietor: Stiliger sp. z o.o., 43-600 Jaworzno (PL)
(72) Inventor: Bogdan, Pietrzyk, 43-600 Jaworzno (PL)

(56) References cited:
- EP-A1- 2 925 104
- GB-A- 2 575 429
- US-A- 4 152 750
- US-A- 5 442 142
- US-A1- 2013 184 840
- US-A1- 2015 362 963
- US-B2- 6 424 547

## Description

The present invention relates to a modular, multi-channel actuator controlling electrical receivers, especially in building automation systems, especially for receivers which are turned on, including lighting, roller blind driver motors, shutters and heating systems.

The state - of - the - art solution DE10331164 is known. It is an actuator, in other words an actuating device, with multiple channels, provided for controlling corresponding functional units using a bus operation mode, and if necessary using manual operations. The operating conditions ( operating mode, that is state - on/off) of the associated functional units are indicated by an associated display element. All activation elements are joined together in a single operating group (BG) with at least two input keys. Each channel has at least an associated display element and all the display elements, e.g. LEDs, are joined together in a separately arranged display group.

According to the description DE202017105437 an electrical modular installation device for the building installation technology is known. This device is designed for installation on the busbar and its housing is equipped with at least one place of a bus connection intended for connecting electrical bus lines and a few places of motor connection intended for connecting electrical motor lines and it is characterised by the fact that electrical lines lead to at least one place of the bus connection. The lines ( cables) of the bus are attached to the fastening elements designed on the housing by means of an elastic fixing tape.

A solution known from the state of the art is US5442142A. It relates to printed board having fasteners that are connected with the busbars may be at different heights so that plural busbars connecting the fasteners can cross each other at plural levels. In this solution there are holes passing through said busbars.

In US 4152750A a pair of spaced side plates are connected together by mounting bars which support a circuit board. Individual I/O modules plug into connectors on the circuit board and are fastened to the mounting bars. Wiring from the controller processor is brought into an adapter module which also plugs into the circuit board and external wiring is brought into terminal blocks which mount along the top and bottom edges of the circuit board. The wire terminals on the terminal blocks are connected to the conductive paths on the circuit board to provide electrical connection with the circuits in the I/O modules. I/O modules are located on the same side.

This solution has different construction with an invention described in said patent description.

The subject of present invention EP2925104 A1 is an interface device optimized for controlling the equipment of an electrical installation. Said device comprising a box having a front interface face and containing an electronic card comprising at least one push button, at least two channels, a movable manual selector between at least two main positions. Presented invention relates to way of connection of canals and controlling system.

US6424547 B2 is a power supply module includes a plurality of power supply modules. One of the power supply units is designated as a master power supply unit. Other power supply units are handled as expansion power supply units. The power supply modules can be connected in parallel on a DIN rail so that the master power supply unit may supply an external AC voltage to the expansion power supply units. When a desired power supply capacity exceeds a power supply capacity of the master power supply unit, an expansion power supply unit is connected in parallel with the master power supply unit in order to increase the power supply capacity. US US6424547 B2 does not mention about particular arrangement of the bridges.

US 2015/362963 relates to a redundant power supply motherboard assembly connects control segments of a fieldbus-type control system to a host computer. The assembly has a compact design with pairs of power supply modules in side-by-side nests on the motherboard. The nests are mounted on the motherboard in desired locations and securely hold the modules on the assembly despite vibrations, shocks and handling to prevent contact impairment. The nests provide touch protection for components on the motherboard. US 2015/362963 relates to way of setup of a module connectors on the motherboard.

US 2013/184840 A1 is a system and method related to a control system including an automation controller with a module bay configured to facilitate coupling with scalable modules. The module bay of the automation controller includes a plurality of bay connectors configured to communicatively couple with the scalable module connectors. The module bay may include an open end to facilitate extension beyond an edge of the open end by a module or a closed end. This solution does not to describe particular arrangement of the bridges and/ or layout of relays.

The - state - of - art actuators have: power inputs and receiver outputs on the top of the housing, at the bottom of the housing, alternatively inputs and outputs around the housing, sometimes in two rows or levels.

The purpose of this invention is to develop a solution which would organize directions of connecting power inputs and receiver outputs as well as reduce the size of actuators, and consequently reduce the neccessity to use big switchboards.

This purpose has been achieved in the presented invention whose core feature is a modular, multi-channel actuator controlling electrical receivers by means of communication bus, having a printed board equipped with an electrical system with relays, power inputs and outputs to receivers located parallel to the longitudinal axis of the printed board and electrical bridges, characterised in that electrical bridges located underneath the board are placed at the angle approximate to the right angle to the longitudinal axis of the printed board and each electrical bridge constitutes alternately the connector of the input /output with the pin of the relay, and wherein the power inputs are placed at one edge of the printed board and the outputs to receivers are placed at the opposite edge of the printed board, and the relays form parallel rows.

Due to the use of electrical bridges and their particular arrangement the following characteristics have been achieved: a significant reduction of the dimensions of the device by at least 25% to 40%, maximum possibile density of the relays on the reduced surface of the printed board as well as the orderly direction of connecting cables to the power inputs and receiver outputs using the through hole technology, that is the power inputs close to one edge of the printed board are being connected by the relay contacts to the receiver outputs located on the opposite edge of the printed board.

The use of electrical bridges simplifies the external design of actuators and it eliminates numerous possibile assembly mistakes. Electrical bridges transfer higher current than copper traces on the printed board.

The special design of the printed board PCB together with the use of bridges and the arrangement of the power inputs close to one edge of the printed board and the receiver outputs close to the edge on the opposite side of the printed board, as well as the arrangement of the bridges guarantees that virtually there is no possibility of making a mistake while connecting the power and the receiver outputs.

Moreover, all the actuator connectors can be disconnected from the printed board without using tools, which enables disconnecting of the device for service in a very short time, without the need to unscrew the cables or to remove them from the connector. The invention also eliminates screw connectors, which reduces the time of connecting the devices. The invention limits the time of testing the connected devices and their configuration.

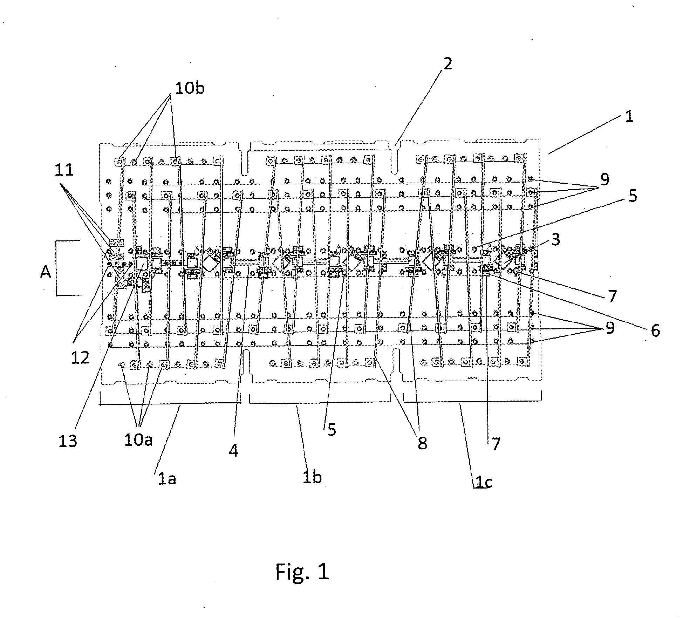

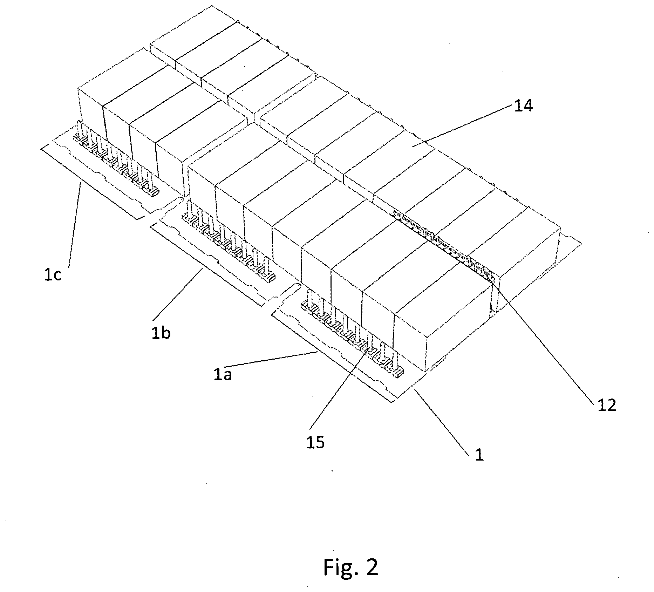

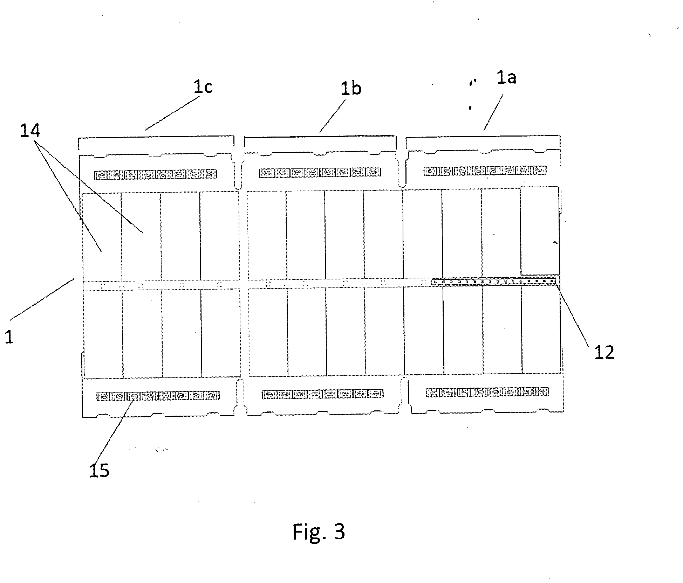

The invention is presented in the figures of the drawing, in which fig. 1 shows the view of the invention from the bottom from the side of the bridge connections, fig.2 shows the invention in the axonometric view from the side of the relays, fig.3 shows the view from the top from the side of the relays, fig.4 shows the view from the top with the fitted upper control board.

The invention is presented according to realisation.

The printed board 1 has the notch 2 positioning the printed board 1 in the housing. The printed board 1 is double - layered. The board is divided into three sections 1a, 1b, 1c.

In the central part A of the printed board 1 integrated circuits 3 are located, in the area of the paths of the printed circuit 4. The passive element 6 constitutes the capacitor. The passive element 7 constitutes the resistor. On both sides of the paths of the circuit 4 there is a row of controlling pins 5 of the relays 14. The relays 14 are controlled by the control systems, the controlling pins 5 constitute the connecting element.

The printed board 1 is equipped with the electrical bridges 8 which create a special arrangement of straight lines distributed placed at the angle approximate to the right angle to the longitudinal axis of the printed board 1.

The electrical bridges 8 are in the form of flat plates. The pins 9 of the relay 14 are arranged in three rows.

The receiver outputs 10a are located at external edges of the printed board 1, and the power inputs 10b are located on the opposite side, which can be seen in the view from the bottom of the board rotated 180 degrees around the longitudinal axis of the board.

The arrangement of the pins 9 in rows enables connecting each electrical bridge 8 alternately from one side respectively with the power input 10b or with the receiver output 10a, and on the other side with the pin 9 of the relay 14, that is with the power input 10b from the bottom of the printed board 1 and with the receiver output 10a from the top of the printed board 1. In the example the relay 14 constitutes the electromagnetic relay.

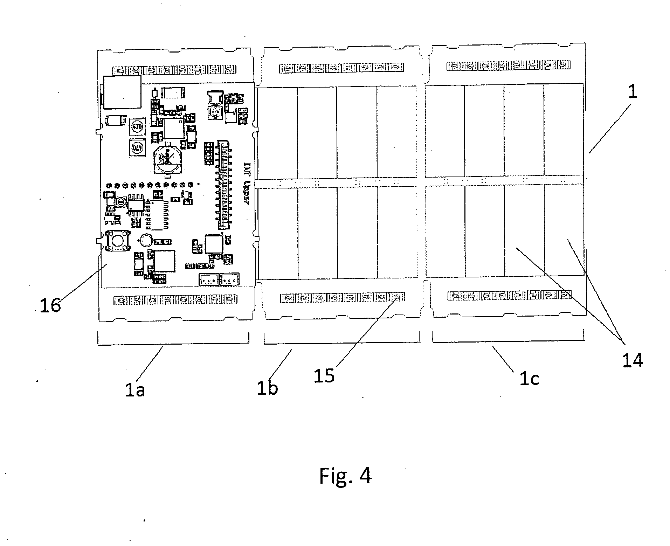

The bus contacts 11 and the integrated circuit 13 are located in the section 1a. The multi-pin connector 12 in the section 1a connects the printed board 1 with the control board 16, which is installed over the printed board 1 with the relays 14 over the part occupying the area of the section 1a. The control board 16 constitutes the printed board 1 and it is shown in the fig.4 to explain the connection of the printed board 1 with the control board 16 by the connector 12. The pin connector 15 in each section 1a, 1b, 1c is used for connecting the power inputs 10b and the receiver outputs 10a by the spring connectors which are mounted on them.

## Claims

1. A modular, multi-channel actuator configured to control electrical receivers by means of communication bus, comprising a printed board (1) equipped with an electrical system with relays (14), power inputs (10b) and outputs (10a) to receivers located parallel to the longitudinal axis of the printed board (1) and electrical bridges (8), **characterised in that** the electrical bridges (8) are located underneath the board (1) and are placed at an angle approximate to the right angle to the longitudinal axis of the printed board (1) and each electrical bridge (8) constitutes alternately the connector of the input (10b) /output (10a) with the pin (9) of the relay (14), and wherein the power inputs (10b) are placed at one edge of the printed board (1) and the outputs (10a) to receivers are placed at the opposite edge of the printed board (1), and the relays (14) form parallel rows.

## Patentansprüche

1. Ein modularer, mehrkanaliger Aktuator, der dazu konfiguriert ist, elektrische Verbraucher mittels eines Kommunikationsbusses zu steuern, mit einer Leiterplatte (1), die mit einem elektrischen System mit Relais (14), Leistungseingängen (10b) und Ausgängen (10a) zu Verbrauchern ausgestattet ist, welche parallel zur Längsachse der Leiterplatte (1) angeordnet sind, und mit elektrischen Brücken (8), **gekennzeichnet dadurch, dass** die elektrischen Brücken (8) unterhalb der Leiterplatte (1) angeordnet sind und in einem Winkel annähernd rechtwinklig zur Längsachse der Leiterplatte (1) positioniert sind, und jede elektrische Brücke (8) abwechselnd den Anschluss des Eingangs (10b) /Ausgangs (10a) mit dem Pin (9) des Relais (14) bildet, wobei die Leistungseingänge (10b) an einer Kante der Leiterplatte (1) positioniert sind und die Ausgänge (10a) zu den Verbrauchern an der gegenüberliegenden Kante der Leiterplatte (1) angeordnet sind, und die Relais (14) parallele Reihen bilden.

## Revendications

1. Actionneur modulaire multivoie configuré pour commander des récepteurs électriques par bus informatique composé de circuit imprimé (1) équipé de circuit électrique avec relais (14), entrées (10b) et sorties (10a) d'alimentation pour récepteurs situés parallèlement à l'axe longitudinal du circuit imprimé (1) et les ponts électriques (8), **caractérisé en ce que** les ponts électriques (8) sont situés sous le circuit (1) et sont orientés sous angle approximativement droit par rapport à l'axe longitudinal du circuit imprimé (1) et chaque pont électrique (8) constitue alternativement le connecteur entre entrée (10b) / sortie (10a) et contact (9) de relais (14), lesdites entrées d'alimentation (10b) sont situées sur le bord du circuit imprimé (1) et les sorties (10a) aux récepteurs sont situées sur le bord opposé du circuit imprimé (1), et les relais (14) forment les rangées parallèles.
